# EUROPÄISCHE PATENTSCHRIFT

(11) **EP 4 736 332 B1**
(45) Veröffentlichungstag und Bekanntmachung des Hinweises auf die Patenterteilung: **11.11.2026**
(21) Anmeldenummer: 24737096.8
(22) Anmeldetag: 27.06.2024
(51) Int. Cl.: H04B 3/54, H04B 3/56

(54) **SENDEEINHEIT UND VERFAHREN ZUM EINKOPPELN EINES ELEKTRISCHEN SENDESIGNALS IN EINE GLEICHSPANNUNGSLEITUNG**
TRANSMISSION UNIT AND METHOD FOR COUPLING AN ELECTRICAL TRANSMISSION SIGNAL INTO A DC VOLTAGE LINE
UNITÉ DE TRANSMISSION ET PROCÉDÉ DE COUPLAGE D'UN SIGNAL DE TRANSMISSION ÉLECTRIQUE DANS UNE LIGNE DE TENSION CONTINUE

(30) Priorität: 29.06.2023 DE 102023117252
(43) Veröffentlichungstag der Anmeldung: 06.05.2026
(73) Patentinhaber: SMA Solar Technology AG, 34266 Niestetal (DE)
(72) Erfinder: BAUER, Dante, 34123 Kassel (DE); SCHNARE, Karsten, 34298 Helsa (DE)
(86) Internationale Anmeldenummer: PCT/EP2024/068155
(87) Internationale Veröffentlichungsnummer: WO 2025/003341

(56) Entgegenhaltungen:
- US-A1- 2014 161 201
- US-B2- 9 374 855

## Beschreibung

### TECHNISCHES GEBIET

Die Anmeldung betrifft eine Sendeeinheit zum Einkoppeln eines elektrischen Sendesignals in eine Gleichspannungsleitung sowie einen Photovoltaik-Wechselrichter mit einer solchen Sendeeinheit. Die Anmeldung betrifft weiter ein Verfahren zum Einkoppeln eines elektrischen Sendesignals in eine Gleichspannungsleitung.

### STAND DER TECHNIK

In Gleichspannungsleitungen einer elektrischen Installation, beispielsweise einer Energieerzeugungsanlage, können elektrische Sendesignale eingeprägt, übertragen und ausgekoppelt werden, insbesondere zur Powerline-Kommunikation zwischen verschiedenen an die Gleichspannungsleitungen angeschlossenen Einrichtungen. Im Falle einer Photovoltaik-Anlage definiert beispielsweise die sogenannte SunSpec Spezifikation der SunSpec Alliance Anforderungen an eine Powerline-Kommunikation (Powerline Communication PLC) zwischen Photovoltaik-Wechselrichtern und elektronischen Einheiten an oder bei den Photovoltaik-Generatoren. Insbesondere Photovoltaik-Anlagen umfassen daher regelmäßig eine Sendeeinheit im Wechselrichter, die ein definiertes elektrisches Sendesignal erzeugt und auf die Gleichspannungsleitungen einkoppelt.

Aus der US 2014/0161201 A1 ist ein Powerline-Kommunikationssystem in PV-Anlagen bekannt, bei dem modulnahe Panel-Controller über die Gleichspannungsleitungen mit einem Wechselrichter kommunizieren, wobei Schalter, Filter und Kommunikationsmodule eingesetzt werden, um Signalverluste zu minimieren. Die US 9,374,855 B2 beschreibt ein bidirektionales Powerline-Kommunikationssystem für Beleuchtungsanlagen, bei dem Strom- bzw. Spannungsmodulation zur Datenübertragung ohne zusätzliche Datenleitungen zwischen Treiber und Lichtmodulen genutzt wird.

### AUFGABE

Der Anmeldung liegt die Aufgabe zugrunde, eine solche Sendeeinheit und ein solches Verfahren zum Einkoppeln eines Sendesignals in eine Gleichspannungsleitung zu verbessern.

### LÖSUNG

Die Aufgabe wird durch eine Sendeeinheit mit den Merkmalen des Anspruchs 1 sowie ein Verfahren mit den Merkmalen des Anspruchs 17 gelöst. Ausführungsformen sind in den abhängigen Ansprüchen angegeben.

### BESCHREIBUNG DER ERFINDUNG

Eine Sendeeinheit koppelt ein elektrisches Sendesignal in eine Gleichspannungsleitung ein. Zur Einkopplung sind zwei Ausgangsanschlüsse vorgesehen, zwischen denen das Sendesignal anliegt. Die Ausgangsanschlüsse sind zur Verbindung mit einem Einkoppelmittel in der Gleichspannungsleitung vorgesehen. Die Sendeeinheit weist eine Verstärkerschaltung mit einem getakteten Verstärker auf. Die Amplitude des Sendesignals ist proportional zu einer Versorgungsspannung des getakteten Verstärkers, wobei die Sendeeinheit eine Kompensationsschaltung umfasst, welche eingerichtet ist, die Amplitude des Sendesignals über eine Differenzspannungsmessung an den Ausgangsanschlüssen zu erfassen und die Versorgungsspannung des getakteten Verstärkers in Abhängigkeit von der Amplitude des Sendesignals einzustellen.

Das elektrische Sendesignal wird also durch die Sendeeinheit erzeugt, über die Ausgangsanschlüsse ausgegeben und über das Einkoppelmittel in die Gleichspannungsleitung eingekoppelt. Die Einkopplung kann grundsätzlich induktiv oder kapazitiv erfolgen, wobei das Einkoppelmittel insbesondere eine Spule zur induktiven Einkopplung umfassen kann. Der getaktete Verstärker der Verstärkerschaltung kann z. B. eine Brückenschaltung mit Schaltern aufweisen, welche getaktet angesteuert werden.

Die Kompensationsschaltung kann insbesondere einen analogen Schaltungsteil zur Differenzspannungsmessung aufweisen. Die Differenzspannungsmessung hat den Vorteil, dass die Amplitude des Sendesignals erfasst werden kann, auch wenn die Ausgangsanschlüsse, zwischen denen das Sendesignal anliegt, keinen definierten Massebezug haben. Optional kann die Kompensationsschaltung ein Gleichrichten und Glätten des Messsignals vornehmen.

Durch eine anmeldungsgemäße Sendeeinheit ist es möglich, das Sendesignal automatisch auf einen gewünschten Amplitudenwert einzustellen und evtl. Abweichungen davon, die z. B. durch Bauteiltoleranzen, Änderungen der Umgebungsbedingungen oder Änderungen der an den Gleichspannungsleitungen angeschlossenen DC-Einheiten hervorgerufen werden können, zu kompensieren. Hierdurch wird die Qualität des elektrischen Sendesignals und damit der Datenübertragung verbessert, ohne dass ein manueller Eingriff in die Sendeeinheit z. B. nach der Montage der Sendeeinheit bzw. des Wechselrichters oder nach Änderungen an der Photovoltaikanlage erforderlich wäre.

In einer Weiterbildung der Sendeeinheit ist die Kompensationsschaltung dazu eingerichtet, ein Kompensationssignal in Abhängigkeit von der Amplitude des Sendesignals auszugeben, um die Versorgungsspannung des getakteten Verstärkers einzustellen. Durch ein solches Kompensationssignal in Abhängigkeit von der Amplitude des Sendesignals kann die reale Amplitude des Sendesignals an den Ausgangsanschlüssen bei der Einstellung der Versorgungsspannung des getakteten Verstärkers Berücksichtigung finden, auch wenn die Versorgungsspannung separat erzeugt wird, d.h. nicht von der Kompensationsschaltung selbst sondern von einer separaten Spannungsversorgung. Die Sendeeinheit wiederum ist so eingerichtet, dass die Amplitude des Sendesignals proportional zur Versorgungsspannung des getakteten Verstärkers ist, so dass durch die beschriebene Ausgestaltung der Kompensationsschaltung die Amplitude auf den gewünschten Wert eingestellt werden kann.

In einer Ausführungsform der Sendeeinheit ist eine nominale DC-Versorgungsspannung vorgesehen, wobei die Versorgungsspannung des getakteten Verstärkers in Abhängigkeit von der nominalen DC-Versorgungsspannung und von dem Kompensationssignal in einem Bereich zwischen der Hälfte der nominalen DC-Versorgungsspannung einer Spannungsversorgung und dem Doppelten der nominalen DC-Versorgungsspannung einstellbar ist. Die nominale DC-Versorgungsspannung kann insbesondere eine nominale Ausgangsspannung einer Spannungsversorgung des getakteten Verstärkers sein, die mittels des Kompensationssignals manipulierbar ist. In Abhängigkeit von dem Kompensationssignal kann dann die Versorgungsspannung des getakteten Verstärkers und damit die Amplitude des Sendesignals im Bereich zwischen der Hälfte und dem Doppelten eines nominalen Wertes verändert werden. Hierdurch kann eine Rückkopplung der realen Amplitude des Sendesignals realisiert werden, um ein Sendesignal mit einer hinreichenden Amplitude zu gewährleisten. Die Versorgungsspannung des getakteten Verstärkers kann insbesondere in einem Bereich von ungefähr 4 Volt bis ungefähr 10 Volt eingestellt werden.

In einer Ausführungsform weist die Sendeeinheit einen DC/DC-Wandler auf, welcher eingerichtet ist, die Versorgungsspannung des getakteten Verstärkers aus einer übergeordneten Bordnetzspannung in Abhängigkeit von der Amplitude des Sendesignals bzw. in Abhängigkeit von dem Kompensationssignal zu erzeugen. Der DC/DC-Wandler kann dabei entweder die Amplitude des Sendesignals oder eine davon abhängige Größe von der Kompensationsschaltung empfangen, um die Versorgungsspannung zu erzeugen. Alternativ kann der DC/DC-Wandler das Kompensationssignal von der Kompensationsschaltung empfangen, um damit die Versorgungsspannung zu erzeugen oder zu skalieren. Das Kompensationssignal kann dabei entweder analog oder digital sein.

In einer Ausführungsform weist die Sendeeinheit einen Prozessor auf, der dazu eingerichtet ist, das Kompensationssignal in digitaler Form als Taktfolge mit einem Tastgrad zu erzeugen und an die Kompensationsschaltung zu übermitteln, wobei der Tastgrad von dem Prozessor in Abhängigkeit von der Amplitude des Sendesignals eingestellt wird. Diese Ausführungsform hat den Vorteil, dass die digitale Signalverarbeitung in dem Prozessor getrennt von der Kompensationsschaltung erfolgen kann, welche als analoge Schaltung ausgebildet sein kann.

In einer Ausführungsform der Sendeeinheit gibt die Kompensationsschaltung die Taktfolge als Kompensationssignal in digitaler Form als Ansteuersignal für Halbleiterschalter des DC/DC-Wandlers aus. In dieser Ausführungsform kann dann die Kompensationsschaltung die Halbleiterschalter des DC/DC-Wandlers direkt ansteuern, was eine schnelle Reaktion des DC/DC-Wandlers und damit eine schnelle Ansteuerung der Erzeugung der Versorgungsspannung erlaubt. Die Ansteuerung der Halbleiterschalter des DC/DC-Wandlers kann dabei alternativ oder zusätzlich zu einer Ansteuerung der Halbleiterschalter durch eine Steuereinheit des DC/DC-Wandlers erfolgen.

In einer Ausführungsform der Sendeeinheit weist die Kompensationsschaltung einen Filter auf, der aus der Taktfolge das Kompensationssignal als Spannungspegel in analoger Form erzeugt und an einen Steuereingang des DC/DC-Wandlers ausgibt. Bei dieser Ausführungsform wirkt das analoge Kompensationssignal als Steuersignal auf die Erzeugung der Versorgungsspannung, insbesondere indem eine nominale Ausgangsspannung des DC/DC-Wandlers mittels des analogen Kompensationssignals skaliert wird.

In einer Ausführungsform der Sendeeinheit sind zwei Sendekanäle über das Sendesignal einkoppelbar. Die Sendeeinheit ist zwischen den zwei Sendekanälen umschaltbar. Die Versorgungsspannung des getakteten Verstärkers bzw. das Kompensationssignal ist in Abhängigkeit von dem Sendekanal zwischen einer ersten und einer zweiten Versorgungsspannung bzw. zwischen einem ersten und einem zweiten Kompensationssignal alternierend umschaltbar. Mit dieser Ausführungsform wird also ein Zweikanalbetrieb der Sendeeinheit ermöglicht, bei welcher die Amplitude des Sendesignals für jeden Kanal unabhängig vom jeweils anderen Kanal gut eingeregelt werden kann.

In einer Ausführungsform der Sendeeinheit weist die Kompensationsschaltung einen Temperatursensor zur Temperaturerfassung auf. Die Versorgungsspannung des getakteten Verstärkers bzw. das Kompensationssignal hängt dabei von der erfassten Temperatur ab. Hierdurch ist eine Kompensation von Temperaturabhängigkeiten möglich, was die Qualität des Sendesignals weiter verbessert.

In einer Ausführungsform der Sendeeinheit ist die Verstärkerschaltung eingerichtet, eine Modulation des Sendesignals in Abhängigkeit von einem binären Vorgabesignal zu erzeugen. Die Verstärkereinheit kann also ein binäres Vorgabesignal in ein moduliertes Sendesignal umwandeln, welches dann in die Gleichspannungsleitung einkoppelbar ist. Das binäre Vorgabesignal kann hierfür z. B. mittels einer Pulsweitenmodulation oder einer Delta-Sigma-Modulation aus einer gewünschten kontinuierlichen Signalform erzeugt werden. Das Sendesignal kann z. B. frequenzmoduliert mit fester vorgegebener Amplitude sein und mehrere, insbesondere zwei alternativ verwendete Frequenzen aufweisen.

In einer Ausführungsform kann der getaktete Verstärker eine Halbbrückenschaltung mit Halbleiterschaltern aufweisen, welche getaktet angesteuert werden. Die Verstärkung der Verstärkerschaltung hängt dabei direkt von der Versorgungsspannung ab, und das Sendesignal wird durch geeignete Taktung der Halbleiterschalter der Halbbrücke erzeugt.

In einer Ausführungsform der Sendeeinheit weist die Verstärkerschaltung eine Klasse D Verstärkerschaltung auf. Die Klasse D Verstärkerschaltung weist einen Klasse D Verstärker auf. Ein Klasse D Verstärker ist ein schaltender Verstärker, der als Leistungsverstärker verwendet werden kann. Der Klasse D Verstärker arbeitet zur Verstärkung eines binären Signals im Schaltbetrieb. Halbleiterleistungsschalter, z. B. Transistoren, der Brückenschaltung des Klasse D Verstärkers werden dabei in zwei diskreten Zustände betrieben, entweder leitend oder isolierend. Hierdurch weist der Klasse D Verstärker wenig Verlustleistung auf.

Ein Photovoltaik-Wechselrichter weist die anmeldungsgemäße Sendeinheit auf. Die Sendeeinheit ist zum Einkoppeln des Sendesignals in die Gleichspannungsleitungen des DC-Busses vorgesehen. Der DC-Bus verbindet den Wechselrichter mit zumindest einem Photovoltaik-Generator zum elektrischen Leistungsaustausch. Der Wechselrichter wird durch die beschriebene Sendeeinheit in die Lage versetzt. über den DC-Bus mit daran angeschlossenen Empfängern zu kommunizieren. Zur Regelung der Amplitude des Sendesignals durch die Sendeeinheit können zudem optional Bauteile verwendet werden, die sowieso im Wechselrichter verbaut sind. Dadurch kann der zusätzliche Aufwand zur Beeinflussung der Amplitude des Sendesignals geringgehalten werden. Zum Beispiel kann die Bordnetzspannung des Wechselrichters zur Erzeugung der Versorgungsspannung der Verstärkerschaltung verwendet werden. Außerdem kann z. B. ein im Wechselrichter vorgesehener DC/DC-Wandler zusätzlich zur Erzeugung der Versorgungsspannung der Verstärkerschaltung aus der Bordnetzspannung verwendet werden. Dies reduziert die Kosten und Komplexität der Sendeeinheit und/oder des Wechselrichters.

Eine Photovoltaik-Anlage kann den beschriebenen Wechselrichter aufweisen. Die Photovoltaik-Anlage kann zudem den zumindest einen Photovoltaik-Generator und den DC-Bus aufweisen. Der DC-Bus verbindet den Wechselrichter mit dem Photovoltaik-Generator zum elektrischen Leistungstransfer. Die Sendeeinheit ermöglicht dann eine Datenkommunikation zwischen dem Wechselrichter und dem Photovoltaik-Generator zugeordneten Empfängern.

Bei einem Verfahren zum Einkoppeln eines Sendesignals in eine Gleichspannungsleitung liegt das Sendesignal zwischen zwei Ausgangsanschlüssen an, die mit einem Einkoppelmittel in der Gleichspannungsleitung verbunden sind. Eine Verstärkerschaltung mit einem getakteten Verstärker erzeugt das Sendesignal mit einer Amplitude proportional zu einer Versorgungsspannung des getakteten Verstärkers. Eine Kompensationsschaltung erfasst die Amplitude des Sendesignals über eine Differenzspannungsmessung an den Ausgangsanschlüssen und stellt die Versorgungsspannung des getakteten Verstärkers geeignet ein.

### KURZBESCHREIBUNG DER FIGUREN

Im Folgenden wird die Anmeldung anhand in den Figuren dargestellter Ausführungsbeispiele weiter erläutert und beschrieben.
- Fig. 1: zeigt schematisch ein erstes Ausführungsbeispiel einer Sendeeinheit.
- Fig. 2: zeigt schematisch ein zweites Ausführungsbeispiel einer Sendeeinheit.
- Fig. 3: zeigt schematisch ein Ausführungsbeispiel einer Photovoltaik-Anlage.
- Fig. 4: zeigt schematisch ein Verfahren zum Einkoppeln eines Sendesignals.
- Fig. 5: illustriert schematisch einen Zweikanalbetrieb.
- Fig. 6: zeigt schematisch ein Verfahren zur Spannungseinstellung für den Zweikanalbetrieb.

Es werden in den Figuren die gleichen Bezugszeichen für gleiche oder ähnliche Elemente verwendet. Die Darstellungen in den Figuren können nicht maßstäblich sein.

### FIGUREN BESCHREIBUNG

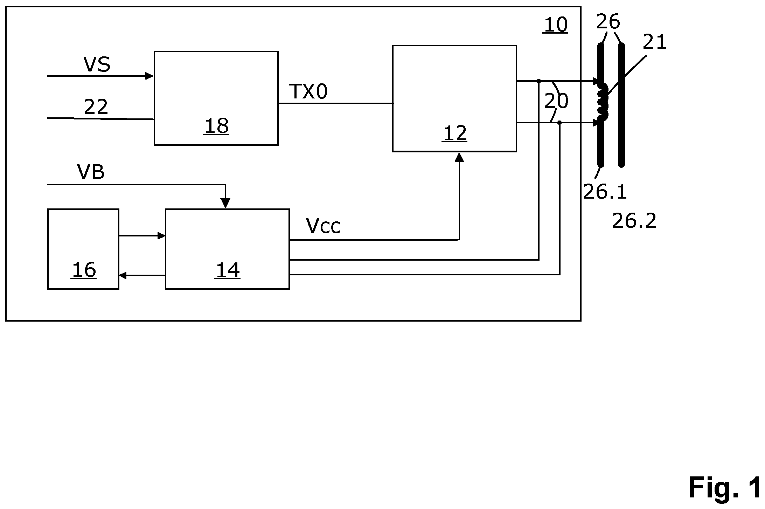

Fig. 1 zeigt ein erstes Ausführungsbeispiel einer Sendeeinheit 10. Die Sendeeinheit 10 ist über Ausgangsanschlüsse 20 mit einem DC-Bus 26 verbunden. Der DC-Bus 26 weist zwei Gleichspannungsleitungen 26.1, 26.2 auf. Die Ausgangsanschlüsse 20 der Sendeeinheit 10 sind mit der einen Gleichspannungsleitung 26.1 des DC-Busses 26 verbunden. Ein zwischen den Ausgangsanschlüssen 20 anliegendes elektrisches Sendesignal kann über ein Einkoppelmittel 21, z. B. eine Induktivität, auf die Gleichspannungsleitung 26.1 eingekoppelt werden. Die Sendeeinheit 10 wird zur Übertragung von Informationen, die im Sendesignal kodiert sind, über den DC-Bus 26 mittels Powerline Kommunikation verwendet. Bei der Sendeeinheit 10 kann es sich z. B. um einen Powerline-Transmitter handeln, der grundsätzlich mit dem SunSpec-Standard und/oder mit ähnlichen einschlägigen Normen zur Kommunikation insbesondere in einer Photovoltaik-Anlage kompatibel ist.

Eine Verstärkerschaltung 12 der Sendeeinheit 10 weist einen getakteten Verstärker auf, welcher insbesondere eine Halbbrücke mit Halbleiterschaltern aufweisen kann. Die Verstärkung des Verstärkers wird durch ein geeignetes getaktetes Schalten einer Versorgungsspannung Vcc mittels der Halbleiterschalter bewirkt. Der Verstärker verstärkt damit ein binäres Vorgabesignal TX0 und erzeugt das elektrische Sendesignal, das dann zwischen den Ausgangsanschlüssen 20 anliegt. Die Verstärkerschaltung ist so ausgebildet, dass eine Amplitude des Sendesignals proportional zu einer Versorgungsspannung Vcc des getakteten Verstärkers ist, und kann dazu z. B. einen Klasse D Verstärker aufweisen.

Ein Signalgenerator 18 wird durch eine Signalgenerator-Versorgungsspannung VS versorgt. Der Signalgenerator 18 gibt ein binäres Vorgabesignal TX0 aus, welches mittels einer Kodierung aus einem an sich kontinuierlich vorgegebenem Signalverlauf erzeugt sein kann. Der vorgegebene Signalverlauf kann insbesondere qualitativ dem Verlauf des gewünschten Sendesignal entsprechen. Geeignete Codierungen des gewünschten Sendesignals bzw. des kontinuierlichen Signalverlaufs sind dabei z. B. eine Delta Sigma Modulation oder eine Pulsweitenmodulation. Ein Eingangssignal 22 kann in den Signalgenerator 18 eingespeichert werden, z. B. über eine Programmierschnittstelle in einen Flash-Speicher. Das Eingangssignal 22 kann identisch mit dem binären Vorgabesignal TX0 sein, welches z. B. für die in Fig. 1 dargestellte einkanalige Sendeeinheit 10 fortlaufend als Sendesignal ausgegeben wird.

Das Vorgabesignal TX0 ist bevorzugt aus einem kontinuierlichen Signal hergeleitet, das z. B. einen gewünschten Signalverlauf mit verschiedene feste Frequenzen mit jeweils fester Amplitude aufweist Der Verstärker 10 übersetzt das Vorgabesignal TX0 durch geeignete Taktung und Filterung aus der codierten binären Form wieder in ein analoges elektrisches Sendesignal, das am Einkoppelmittel 21 angelegt wird. Die Amplitude des Sendesignals am Einkoppelmittel 21 ist dabei einerseits proportional zu der Versorgungsspannung Vcc des getakteten Verstärkers und kann andererseits aufgrund von Toleranzen von Bauteilen der Verstärkerschaltung eine Streuung aufweisen sowie abhängig von Umgebungsbedingungen oder von den am DC-Bus 26 angeschlossenen DC-Einheiten variieren. Ein genaues Erfassen, Kontrollieren und Einstellen der Amplitude des Sendesignals ist daher für die Qualität der Datenübertragung über den DC-Bus von Vorteil.

Dabei kann eine Streuung oder ungewünschte Variation der Amplitude des Sendesignals anmeldungsgemäß kompensiert werden. Die Streuung kann z. B. aufgrund von BauteilToleranzen auftreten, und eine Variation der Amplitude des Sendesignals kann z. B. durch eine Alterung von Keramikkondensatoren und/oder durch temperaturbedinge Abhängigkeiten und/oder in der Abhängigkeit von elektrischen Parametern eines angeschlossenen PV-Generators 36 auftreten.

Die Sendeeinheit 10 weist eine Kompensationsschaltung 14 auf, welche aus einer Bordnetzspannung VB mit elektrischer Leistung versorgt wird und den getakteten Verstärker mit der Versorgungsspannung Vcc versorgt. Optional kann die Versorgungsspannung Vcc des getakteten Verstärkers dabei durch die Kompensationsschaltung 14 selbst aus der Bordnetzspannung VB erzeugt werden.

Die Kompensationsschaltung 14 erfasst außerdem an den Ausgangsanschlüssen 20 das elektrische Sendesignal über eine Differenzspannungsmessung. Die Kompensationsschaltung ist ausgebildet, die Versorgungsspannung Vcc des getakteten Verstärkers in Abhängigkeit von der Amplitude des Sendesignals einzustellen. Dies hat den Vorteil, dass die aktuelle, reale Amplitude des Sendesignals an den Ausgangsanschlüssen 20 erfasst werden kann und die Versorgungsspannung Vcc des getakteten Verstärkers entsprechend angepasst werden kann, um die Amplitude an den Sollwert anzupassen.

Die Erfassung der Amplitude des Sendesignals und das Einstellen der Versorgungsspannung Vcc des getakteten Verstärkers kann dabei mittels einer analogen Schaltungsanordnung der Kompensationsschaltung 14 erfolgen.

Optional kann eine von der erfassten Amplitude des Sendesignals abhängige Information über die Kompensationsschaltung 14 an einen Prozessor 16 übergeben werden. Der Prozessor 16 kann in Abhängigkeit von dieser Information ein digitales Kompensationssignal erzeugen, das z. B. als Taktfolge mit einem Tastgrad von dem Prozessor 16 an die Kompensationsschaltung 14 übermittelt werden kann. Dabei kann der Tastgrad des digitalen Kompensationssignals in Abhängigkeit von der Amplitude des Sendesignals durch den Prozessor 16 eingestellt werden, z. B. mittels eines Proportional-Reglers und/oder eines Proportional-Reglers, jeweils ggf. mit einer Kennlinie. Das Einstellen der Versorgungsspannung Vcc des getakteten Verstärkers kann dann durch die Kompensationsschaltung 14 in Abhängigkeit von dem von dem Prozessor 16 erhaltenen digitalen Kompensationssignal erfolgen, insbesondere durch getaktetes Schalten der Bordnetzspannung VB entsprechend der Taktfolge des vom Prozessor 16 empfangenen digitalen Kompensationssignals. In einer Grundausführung kann die Kompensationsschaltung 14 neben der Differenzspannungserfassung die analoge Signalaufbereitung der gemessenen Signale zum Prozessor 16 und des getakteten Kompensationssignals vom Prozessor 16 durch Filter oder ähnliches umfassen.

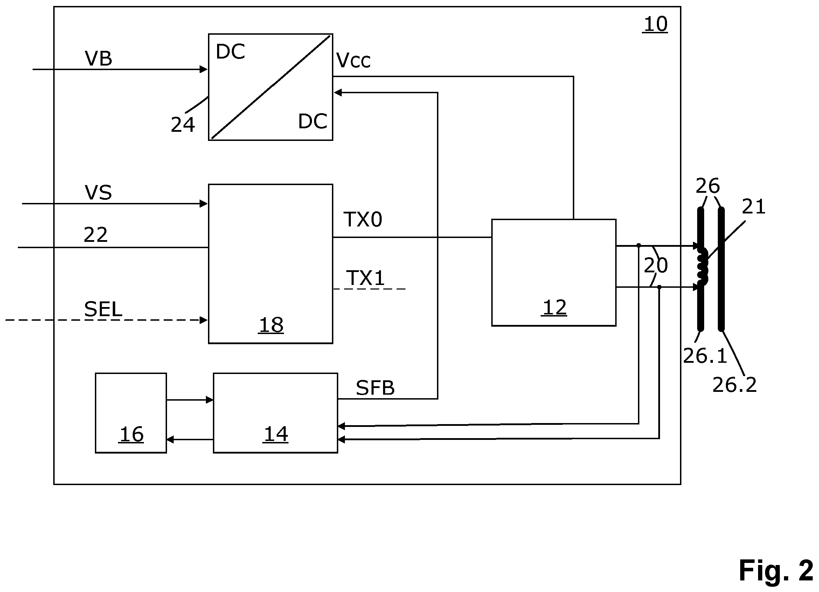

In Fig. 2 ist ein zweites Ausführungsbeispiel der Sendeeinheit 10 dargestellt. Im Unterschied zu Fig. 1 weist die Sendeeinheit 10 in diesem Ausführungsbeispiel einen DC/DC-Wandler 24 auf. Der DC/DC-Wandler 24 ist z. B. getaktet ausgeführt und weist ansteuerbare Halbleiterschalter auf. Der DC/DC-Wandler 24 generiert die Versorgungsspannung Vcc für die Verstärkerschaltung 12 aus der Bordnetzspannung VB in Abhängigkeit von einem Kompensationssignal SFB, das von der Kompensationsschaltung 14 empfangen wird. Die Kompensationsschaltung 14 selbst kann auch in diesem Ausführungsbeispiel von der Bordnetzspannung VB mit elektrischer Energie versorgt werden.

Die Kompensationsschaltung 14 generiert das Kompensationssignal SFB in Abhängigkeit der Amplitude des Sendesignals. Die Amplitude des Sendesignals kann in analoger Weise wie bei der Sendeeinheit 10 von Fig. 1 erfasst werden. Die gemessene Amplitude oder eine dazu proportionale Information kann an einen Prozessor 16 weitergeleitet werden, der in Abhängigkeit von dieser Information mittels eines Reglers und/oder einer Kennlinie ein digitales Kompensationssignal erzeugen und an die Kompensationsschaltung 14 zurückgeben kann.

Die Kompensationsschaltung 14 kann in diesem Ausführungsbeispiel ein Kompensationssignal SFB ausgeben, das in digitaler Form als Ansteuersignal für Halbleiterschalter des DC/DC-Wandlers 24 geeignet ist. Die Kompensationsschaltung 14 kann dann z. B. die Halbleiterschalter des DC/DC-Wandlers 24 direkt ansteuern, insbesondere wenn das vom Prozessor 16 erzeugte digitale Kompensationssignal direkt oder nach geeigneter Filterung als Kompensationssignal SFB verwendet wird.

Die Kompensationsschaltung 14 kann auch einen Filter aufweisen, der aus dem vom Prozessor 16 empfangenen digitalen Kompensationssignal einen Spannungspegel in analoger Form erzeugt und diesen Spannungspegel als Kompensationssignal SFB an einen Steuereingang des DC/DC-Wandlers ausgibt. Das Kompensationssignal SFB kann dann direkt die vom DC/DC-Wandler 24 auszugebende Versorgungsspannung Vcc vorgeben oder eine nominalen DC-Versorgungsspannung des DC/DC-Wandlers 24 modifizieren, also eine Skalierung der Versorgungsspannung Vcc bewirken. Alternativ wäre möglich, das Kompensationssignal SFB direkt als Versorgungsspannung des DC/DC-Wandlers 24 zu verwenden, d.h. anstelle der Bordnetzspannung VB (hier nicht dargestellt).

Die Sendeeinheit 10 ist zur zweikanaligen Übertragung ausgelegt, so dass die Sendeeinheit zwischen mindestens zwei Sendekanälen umschaltbar ist, wobei das jeweilige Sendesignal über die mindestens zwei Sendekanäle in verschiedene DC-Busse einkoppelbar ist. Der aktuell verwendete Kanal kann dabei über ein Kanalauswahlsignal SEL ausgewählt werden. Der Signalgenerator 18 kann alternierend zwei binäre Vorgabesignale TX0, TX1 ausgeben, wobei das erste Vorgabesignal TX0 bei einer Versorgungsspannung Vcc mit einem ersten Wert über die Verstärkerschaltung 12 an die Ausgangsanschlüsse 20 ausgegeben wird, während das zweite Vorgabesignal TX1 bei einer Versorgungsspannung Vcc mit einem zweiten, vom ersten abweichenden Wert über eine nicht dargestellte zweite Verstärkerschaltung an deren Ausgangsanschlüsse ausgegeben und in einen zweiten nicht dargestellten DC-Bus eingekoppelt wird. Das Eingangssignal 22 kann dabei identisch mit dem jeweiligen binären Vorgabesignal TX0, TX1 sein, welche fortlaufend alternierend ausgegeben werden können. Das Kompensationssignal SFB ist in Abhängigkeit von dem Sendekanal zwischen einem ersten und einem zweiten Kompensationssignal SFB alternierend umschaltbar, wobei das erste Kompensationssignal SFB in Abhängigkeit von der Amplitude des Sendesignals am Einkoppelmittel 21 und das zweite Kompensationssignal SFB in Abhängigkeit von der Amplitude des Sendesignals an einem weiteren nicht dargestellten Einkoppelmittel in einer Gleichspannungsleitung des zweiten, hier nicht dargestellten DC-Bus erzeugt wird. Dadurch wird ermöglicht, zumindest die Bauteile Kompensationsschaltung 14, Prozessor, Signalgenerator 18 und DC/DC-Wandler 24 mehrfach zur Erzeugung von PLC-Signales auf verschiedenen DC-Bussen mit etwaiger voneinander abweichender Belegung mit DC-Einheiten zu verwenden.

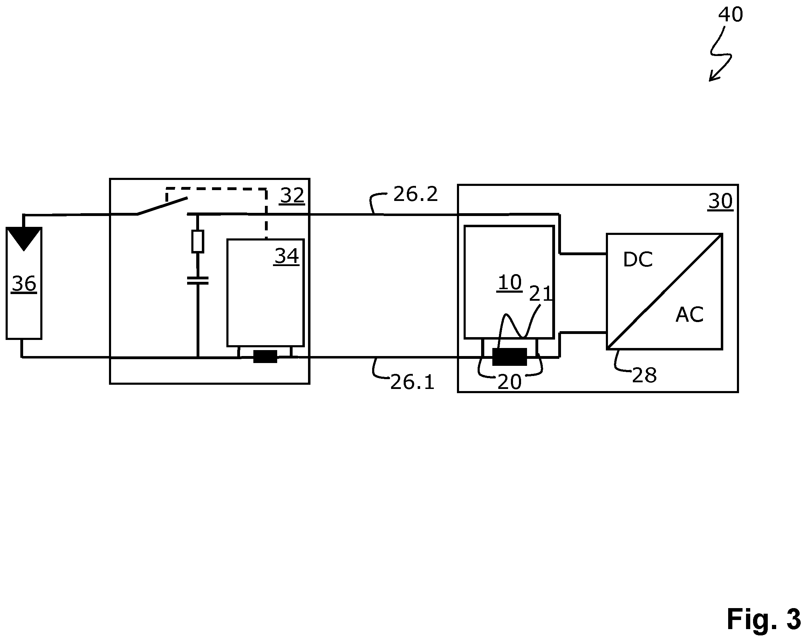

In Fig. 3 ist schematisch eine Photovoltaik-Anlage 40 mit einem Wechselrichter 30, einem DC-Bus mit den Gleichspannungsleitungen 26.1 und 26.2, einem PV-Generator 36 und einer Trennschaltung 32 dargestellt. Bei mehreren PV-Generatoren 36, die in Reihe an dem einen DC-Bus oder parallel über mehrere DC-Busse an dem Wechselrichter 30 angeschlossen sein können, kann jeweils eine Trennschaltung 32 pro DC-Bus oder pro PV-Generator 36 vorgesehen sein.

Der Wechselrichter 30 weist eine Wechselrichterbrücke 28 und für jeden angeschlossenen DC-Bus zumindest ein Einkoppelmittel 21 auf. Das Einkoppelmittel 21 ist vorgesehen, um das Sendesignal, das zwischen den Ausgangsanschlüssen 20 der Sendeeinheit 10 anliegt, in eine Gleichspannungsleitung 26.1 des DC-Busses 26 einzukoppeln.

Die Trennschaltung 32 stellt beispielhaft einen Empfänger für das Sendesignal dar und weist eine Empfangseinheit 34 auf, welche eingerichtet ist, das von der Sendeinheit 10 ausgesandte Sendesignal zu empfangen. In Abhängigkeit von dem empfangenen Sendesignal kann die Trennschaltung 21 den PV-Generator 36 beispielsweise durch Öffnen eines elektronischen DC-Schalters von dem Wechselrichter 30 trennen oder durch Schließen des elektronischen DC-Schalters mit dem Wechselrichter 30 verbinden.

Über eine solche Trennschaltung 32 mit der Empfangseinheit 34 für die Kommunikation über den DC-Bus lässt sich z. B. eine einfehlersichere Ein- und Ausschaltvorrichtung für PV-Generatoren realisieren. Ein Vorteil der Kommunikation über den DC-Bus 26 liegt darin, dass keine zusätzliche Verkabelung installiert oder Funkschnittstellen bereitgestellt werden müssen. Erzeugt und eingekoppelt wird das Sendesignal für die Kommunikation über den DC-Bus wie beschrieben z. B. durch die Sendeeinheit 10 im Wechselrichter, wobei durch die anmeldungsgemäße Kompensationsschaltung eine ausreichende Signalqualität des Sendesignal gewährleistet wird.

Um eine Einfehler-Sicherheit der PV-Anlage 40 zu gewährleisten, kann z. B. während des Normalbetriebs der PV-Anlage 40 ein bestimmtes Signal z. B. im Sekundentakt durch die Sendeeinheit 10 gesendet werden. Die Trennschaltung 32 wertet das über die Empfangseinheit 34 empfangene Signal aus und schaltet bei Detektion des korrekten Bitstroms die DC-Spannung des PV-Generators 36 auf den DC-Bus durch. Sollte nun z. B. der DC-Bus 26 unterbrochen sein oder der Wechselrichter 30 einen Defekt aufweisen oder die PV-Anlage 40 aus sonstigen Gründen abgeschaltet werden, sodass das Signal nicht mehr den PV-Generator 36 erreicht, so kann die Trennschaltung 32 automatisch den PV-Generator 36 abschalten. Somit kann die gesamte PV-Anlage 40 bei Bedarf zuverlässig spannungsfrei geschaltet werden.

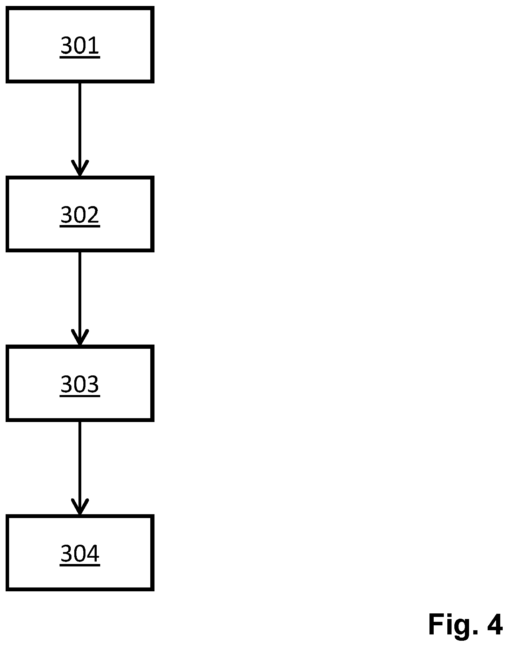

Fig. 4 zeigt schematisch ein Verfahren zum Einkoppeln des Sendesignals in die Gleichspannungsleitung 26.1. Das Sendesignal liegt zwischen den zwei Ausgangsanschlüssen 20 an, die mit dem Einkoppelmittel 21 in der Gleichspannungsleitung 26.1 verbunden sind.

In 301 erfasst die Kompensationsschaltung 14 die Amplitude des Sendesignals über eine Differenzspannungsmessung an den Ausgangsanschlüssen 20, welche mit dem Einkoppelmittel 21 verbunden sind. In 302 richtet die Kompensationsschaltung 14 die erfasste Spannung des Sendesignals z. B. mittels einer Diode gleich. In 303 glättet die Kompensationsschaltung 14 die erfasste gleichgerichtete Spannung. Die Glättung kann z. B. durch eine Art Spitzenwertbildung durch Integration der gleichgerichteten Spannung erfolgen. In 304 stellt die Kompensationsschaltung 14 die Versorgungsspannung Vcc des getakteten Verstärkers ein. Das Einstellen in 304 kann z. B. durch ein direktes Einstellen der Versorgungsspannung Vcc durch die Kompensationsschaltung 14 (vergleiche Fig. 1) oder durch die Ausgabe des Kompensationssignals SFB an einen DC/DC-Wandler 24 (vergleiche Fig. 2) erfolgen.

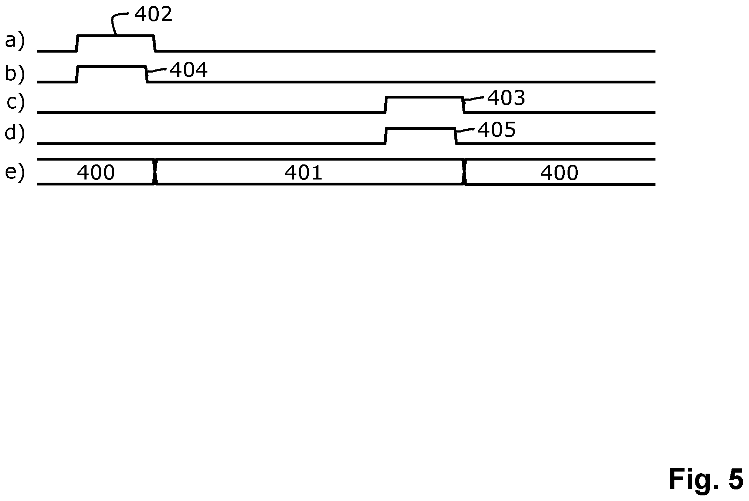

Fig. 5 illustriert schematisch einen Zweikanalbetrieb. In Fig. 5 e) sind diejenigen Zeiträume mit 400 für einen ersten Kanal bezeichnet, in denen die Versorgungspannung Vcc für den getakteten Verstärker mit Anschluss an einen ersten DC-Bus durch Rückkopplung der Amplitude des Sendesignals an diesem ersten DC-Bus optimiert ist, und mit 401 sind diejenigen Zeiträume für einen zweiten Kanal bezeichnet, in denen die Versorgungspannung Vcc für den getakteten Verstärker mit Anschluss an einen zweiten DC-Bus durch Rückkopplung der Amplitude des Sendesignals an diesem ersten DC-Bus optimiert ist. In Fig. 5a) ist mit 402 der Zeitraum bezeichnet, in dem das Sendesignal des ersten Kanals aktiv ist, während weitgehend zeitgleich im Zeitraum 404 die Regelung der Versorgungsspannung Vcc in Abhängigkeit von der gemessenen Amplitude der Sendesignals auf dem ersten Kanal aktiv ist. Nach der Umschaltung der Versorgungsspannung Vcc auf den zweiten Kanal beginnt dann bei 403 die Aktivität des zweiten Kanals und entsprechend findet während 405 die Regelung der Versorgungsspannung Vcc in Abhängigkeit von der gemessenen Amplitude der Sendesignals auf dem zweiten Kanal statt. Fig. 5 ist zu entnehmen, dass die Kanäle jeweils in der Sendepause des anderen Kanals senden. Die Regelung der Versorgungsspannung Vcc wird vorausschauend bereits vor der Aktivität Sendesignals des jeweiligen Kanals begonnen.

Die Umsetzung des Zweikanalbetriebs ist durch die alternierende Arbeitsweise möglich. Per Software sind hierzu zwei unabhängige Regelprozesse definiert. Durch die vorausschauende Spannungsumschaltung ist ein nahtloser Wechsel zwischen den Kanälen möglich.

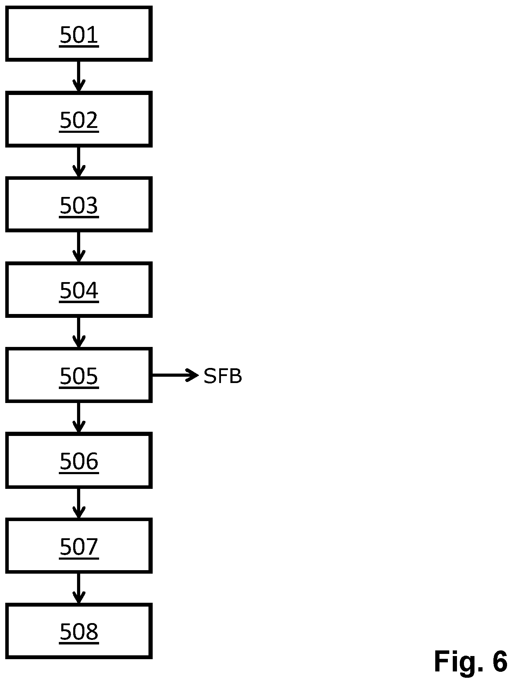

Fig. 6 zeigt schematisch ein Verfahren zur Spannungseinstellung für den Zweikanalbetrieb. Das Verfahren gemäß Fig. 6 kann z. B. in dem Prozessor 16 ablaufen. In 501 wird empfangen, welcher Kanal aktiv ist. In 502 werden die digitalisierten Werte der geglätteten Amplitude des Sendesignals des aktiven Kanals empfangen. In 503 wird über die in 502 empfangenen Werte zur Störungsunterdrückung der Mittelwert gebildet. In 504 wird der Regelalgorithmus zur Amplitudeneinstellung durchgeführt. In 505 wird das Kompensationssignal SFB, z. B. in Form eines Tastverhältnisses oder eines analogen Spannungspegels erzeugt und zur Einstellung der Versorgungsspannung Vcc verwendet. In 506 wird gewartet bis der jeweilige aktuell aktive Kanal ausgeschaltet wird, und in 507 wird die Regelung der Versorgungspannung Vcc auf die Abhängigkeit von der Amplitude des Sendesignals des anderen Kanals umgeschaltet. In 508 wird optional die Temperatur der Sendeeinheit 10 gemessen, um eine optionale zusätzliche Temperaturkompensation durchführen zu können.

Durch die Verwendung der aktiven Regelung kann die Amplitude des Sendesignals sehr eng toleriert an der geforderten Amplitude gehalten werden. Die Abweichungen, die z. B. durch Bauteiltoleranzen entstehen, können zuverlässig ausgeregelt werden. Durch die Verwendung des gemittelten Messwerts in der Regelung, kann statt mit der einzelnen Schwingung der Amplitude als Regelgröße, mit dem gesamten Ausgangssignal als Regelgröße gearbeitet werden. Dadurch ist die Regelung robust gegen Störungen, wie z. B. Oberwellen aus dem Wechselrichter 30.

### BEZUGSZEICHENLISTE

- 10: Sendeeinheit
- 12: Verstärkerschaltung
- 14: Kompensationsschaltung
- 16: Prozessor
- 18: Signalgenerator
- 20: Ausgangsanschlüsse
- 21: Einkoppelmittel
- 22: Eingangssignal
- 24: DC/DC-Wandler
- 26: DC-Bus
- 26.1, 26.2: Gleichspannungsleitungen
- 28: Wechselrichterbrücke
- 30: Wechselrichter
- 32: Trennschaltung
- 34: Empfangseinheit
- 36: Photovoltaik (PV)-Generator
- 40: Photovoltaik (PV)-Anlage
- VB: Bordnetzspannung
- Vcc: Versorgungsspannung
- VS: Signalgenerator-Versorgungsspannung
- SEL: Kanalauswahl
- SFB: Kompensationssignal
- TX0: binäres Vorgabesignal erster Sendekanal
- TX1: binäres Vorgabesignal zweiter Sendekanal
- 400, 401: Spannungseinstellung Sendekanäle
- 402, 404: Aktivität Sendekanäle
- 403, 405: Aktivität Regelung Sendekanäle
- 301-304, 501-508: Verfahrensschritte

## Patentansprüche

1. Sendeeinheit (10) zum Einkoppeln eines elektrischen Sendesignals in eine Gleichspannungsleitung (26.1, 26.2) mit zwei Ausgangsanschlüssen (20), zwischen denen das Sendesignal anliegt und die zur Verbindung mit einem Einkoppelmittel (21) in der Gleichspannungsleitung (26.1, 26.2) vorgesehen sind, wobei die Sendeeinheit (10) eine Verstärkerschaltung (12) mit einem getakteten Verstärker aufweist und die Amplitude des Sendesignals proportional zu einer Versorgungsspannung (Vcc) des getakteten Verstärkers ist,
wobei die Sendeeinheit (10) eine Kompensationsschaltung (14) umfasst, welche eingerichtet ist, die Amplitude des Sendesignals über eine Differenzspannungsmessung an den Ausgangsanschlüssen (20) zu erfassen und die Versorgungsspannung (Vcc) des getakteten Verstärkers in Abhängigkeit von der Amplitude des Sendesignals einzustellen.

2. Sendeeinheit (10) nach Anspruch 1, wobei die Kompensationsschaltung (14) dazu eingerichtet ist, ein Kompensationssignal (SFB) in Abhängigkeit von der Amplitude des Sendesignals auszugeben, um die Versorgungsspannung (Vcc) des getakteten Verstärkers einzustellen.

3. Sendeeinheit (10) nach Anspruch 2, wobei eine nominale DC-Versorgungsspannung vorgesehen ist, wobei die Versorgungsspannung (Vcc) des getakteten Verstärkers in Abhängigkeit von der nominalen DC-Versorgungsspannung und von dem Kompensationssignal (SFB) in einem Bereich zwischen der Hälfte der nominalen DC-Versorgungsspannung und dem Doppelten der nominalen DC-Versorgungsspannung, insbesondere in einem Bereich von ungefähr 4 Volt bis ungefähr 10 Volt einstellbar ist.

4. Sendeeinheit (10) nach einem der vorhergehenden Ansprüche, aufweisend einen DC/DC-Wandler (24), welcher eingerichtet ist, die Versorgungsspannung (Vcc) aus einer übergeordneten Bordnetzspannung (VB) in Abhängigkeit von der Amplitude des Sendesignals bzw. in Abhängigkeit von dem Kompensationssignal (SFB) zu erzeugen.

5. Sendeeinheit (10) nach einem der vorhergehenden Ansprüche, wobei das durch die Kompensationsschaltung (14) ausgegebene Kompensationssignal (SFB) analog oder digital ist.

6. Sendeeinheit (10) nach einem der Ansprüche 2 bis 5, wobei die Sendeeinheit (10) einen Prozessor (16) aufweist, der dazu eingerichtet ist, das Kompensationssignal (SFB) in digitaler Form als Taktfolge mit einem Tastgrad zu erzeugen und an die Kompensationsschaltung (14) zu übermitteln, wobei der Tastgrad von dem Prozessor (16) in Abhängigkeit von der Amplitude des Sendesignals eingestellt wird.

7. Sendeeinheit (10) nach Anspruch 6, wobei die Kompensationsschaltung (14) die Taktfolge als Kompensationssignal (SFB) in digitaler Form als Ansteuersignal für Halbleiterschalter des DC/DC-Wandlers (24) ausgibt.

8. Sendeeinheit (10) nach Anspruch 6, wobei die Kompensationsschaltung (14) einen Filter aufweist, der aus der Taktfolge das Kompensationssignal (SFB) als Spannungspegel in analoger Form erzeugt und an einen Steuereingang des DC/DC-Wandlers (24) ausgibt.

9. Sendeeinheit (10) nach einem der vorhergehenden Ansprüche, wobei zwei Sendekanäle über das Sendesignal einkoppelbar sind, wobei die Sendeeinheit (10) zwischen den zwei Sendekanälen umschaltbar ist, und wobei die Versorgungsspannung (Vcc) des getakteten Verstärkers bzw. das Kompensationssignal in Abhängigkeit von dem Sendekanal zwischen einer ersten und einer zweiten Versorgungsspannung bzw. zwischen einem ersten und einem zweiten Kompensationssignal (SFB) alternierend umschaltbar ist.

10. Sendeeinheit (10) nach einem der vorhergehenden Ansprüche, wobei die Kompensationsschaltung (14) einen Temperatursensor zur Temperaturerfassung (508) aufweist und wobei die Versorgungsspannung (Vcc) des getakteten Verstärkers bzw. das Kompensationssignal (SFB) von der erfassten Temperatur abhängt.

11. Sendeeinheit (10) nach einem der vorhergehenden Ansprüche, wobei die Verstärkerschaltung (12) eingerichtet ist, eine Modulation des Sendesignals in Abhängigkeit von einem binären Vorgabesignal (TX0, TX1) zu erzeugen.

12. Sendeeinheit (10) nach einem der vorhergehenden Ansprüche, wobei der getaktete Verstärker eine Halbbrückenschaltung mit Halbleiterleistungsschaltern aufweist oder wobei die Verstärkerschaltung (12) eine Klasse D Verstärkerschaltung aufweist.

13. Photovoltaik-Wechselrichter (30) mit einer Sendeinheit (10) nach einem der vorhergehenden Ansprüche, wobei die Sendeeinheit (10) zum Einkoppeln des Sendesignals in die Gleichspannungsleitung (26.1, 26.2) vorgesehen ist, wobei ein DC-Bus (26) die Gleichspannungsleitung (26.1, 26.2) aufweist, und der DC-Bus (26) den Wechselrichter (30) mit zumindest einem Photovoltaik-Generator (36) zum elektrischen Leistungsaustausch verbindet.

14. Photovoltaik-Anlage (40) mit einem Wechselrichter (30) nach Anspruch 13, dem zumindest einen Photovoltaik-Generator (36) und dem DC-Bus (26) zum elektrischen Leistungstransfer.

15. Verfahren zum Einkoppeln eines Sendesignals in eine Gleichspannungsleitung (26.1, 26.2), wobei das Sendesignal zwischen zwei Ausgangsanschlüssen (20) anliegt, die mit einem Einkoppelmittel (21) in der Gleichspannungsleitung (26.1, 26.2) verbunden sind, wobei eine Verstärkerschaltung (12) mit einem getakteten Verstärker das Sendesignal mit einer Amplitude proportional zu einer Versorgungsspannung (Vcc) des getakteten Verstärkers erzeugt, wobei eine Kompensationsschaltung (14) die Amplitude des Sendesignals über eine Differenzspannungsmessung an den Ausgangsanschlüssen (20) erfasst und die Versorgungsspannung (Vcc) des getakteten Verstärkers einstellt.

## Claims

1. A transmitter unit (10) for coupling an electrical transmission signal into a DC voltage line (26.1, 26.2), comprising two output terminals (20) between which the transmission signal is applied and which are provided for connecting to a coupling means (21) in the DC voltage line (26.1, 26.2), wherein the transmitter unit (10) comprises an amplifier circuit (12) with a clocked amplifier, and wherein the amplitude of the transmission signal is proportional to a supply voltage (Vcc) of the clocked amplifier,
wherein the transmitter unit (10) comprises a compensation circuit (14) which is configured to detect the amplitude of the transmission signal via a differential voltage measurement at the output terminals (20) and to set the supply voltage (Vcc) of the clocked amplifier depending on the amplitude of the transmission signal.

2. The transmitter unit (10) according to claim 1, wherein the compensation circuit (14) is configured to output a compensation signal (SFB) depending on the amplitude of the transmission signal in order to set the supply voltage (Vcc) of the clocked amplifier.

3. The transmitter unit (10) according to claim 2, wherein a nominal DC supply voltage is provided, wherein the supply voltage (Vcc) of the clocked amplifier is adjustable as a function of the nominal DC supply voltage and of the compensation signal (SFB) within a range between half the nominal DC supply voltage and twice the nominal DC supply voltage, in particular within a range of approximately 4 volts to approximately 10 volts.

4. The transmitter unit (10) according to any one of the preceding claims, comprising a DC/DC converter (24) which is configured to generate the supply voltage (Vcc) from a higher-level system voltage (VB) as a function of the amplitude of the transmission signal or as a function of the compensation signal (SFB)

5. The transmitter unit (10) according to any one of the preceding claims, wherein the compensation signal (SFB) output by the compensation circuit (14) is analog or digital.

6. The transmitter unit (10) according to any one of claims 2 to 5, wherein the transmitter unit (10) comprises a processor (16) which is configured to generate the compensation signal (SFB) in digital form as a clock sequence with a duty cycle and to transmit it to the compensation circuit (14), wherein the duty cycle is set by the processor (16) depending on the amplitude of the transmission signal.

7. The transmitter unit (10) according to claim 6, wherein the compensation circuit (14) outputs the clock sequence as a compensation signal (SFB) in digital form as a control signal for semiconductor switches of the DC/DC converter (24).

8. The transmitter unit (10) according to claim 6, wherein the compensation circuit (14) comprises a filter which generates the compensation signal (SFB) from the clock sequence as a voltage level in analog form and outputs it to a control input of the DC/DC converter (24).

9. The transmitter unit (10) according to any one of the preceding claims, wherein the transmission signal can be coupled into two transmission channels, wherein the transmitter unit (10) can be switched between the two transmission channels, and wherein the supply voltage (Vcc) of the clocked amplifier or the compensation signal can be switched in alternating fashion between a first and a second supply voltage or between a first and a second compensation signal (SFB) depending on the transmission channel.

10. The transmitter unit (10) according to any one of the preceding claims, wherein the compensation circuit (14) has a temperature sensor for temperature detection (508) and wherein the supply voltage (Vcc) of the clocked amplifier or the compensation signal (SFB) depends on the detected temperature.

11. The transmitter unit (10) according to any one of the preceding claims, wherein the amplifier circuit (12) is configured to generate a modulation of the transmission signal depending on a binary setting signal (TX0, TX1).

12. The transmitter unit (10) according to any one of the preceding claims, wherein the clocked amplifier comprises a half-bridge circuit with semiconductor power switches, or wherein the amplifier circuit (12) comprises a class D amplifier circuit

13. A photovoltaic inverter (30) comprising a transmitter unit (10) according to any one of the preceding claims, wherein the transmitter unit (10) is provided for coupling the transmitter signal into the DC voltage line (26.1, 26.2), wherein a DC bus (26) comprises the DC voltage line (26.1, 26.2), and the DC bus (26) connects the inverter (30) to at least one photovoltaic generator (36) for electrical power exchange.

14. A photovoltaic system (40) comprising an inverter (30) according to claim 15, the at least one photovoltaic generator (36), and the DC bus (26) for electrical power transfer.

15. A method for coupling a transmission signal into a DC voltage line (26.1, 26.2), wherein the transmission signal is applied between two output terminals (20) which are connected to a coupling means (21) in the DC voltage line (26.1, 26.2),
wherein an amplifier circuit (12) with a clocked amplifier generates the transmission signal with an amplitude proportional to a supply voltage (Vcc) of the clocked amplifier, wherein a compensation circuit (14) detects the amplitude of the transmission signal via a differential voltage measurement at the output terminals (20) and sets the supply voltage (Vcc) of the clocked amplifier.

## Revendications

1. Unité d'émission (10) destinée à injecter un signal d'émission électrique dans une ligne de tension continue (26.1, 26.2) comportant deux bornes de sortie (20) entre lesquelles le signal d'émission est présent et qui sont prévues pour être raccordées à un moyen d'injection (21) dans la ligne de tension continue (26.1, 26.2) ; l'unité d'émission (10) comportant un circuit amplificateur (12) avec un amplificateur cadencé, et l'amplitude du signal d'émission étant proportionnelle à une tension d'alimentation (Vcc) de l'amplificateur cadencé,
l'unité d'émission (10) comprenant un circuit de compensation (14) qui est agencé pour détecter l'amplitude du signal d'émission par le biais d'une mesure de tension différentielle au niveau des bornes de sortie (20) et pour régler la tension d'alimentation (Vcc) de l'amplificateur cadencé en fonction de l'amplitude du signal d'émission.

2. Unité d'émission (10) selon la revendication 1, dans laquelle le circuit de compensation (14) est agencé pour délivrer un signal de compensation (SFB) en fonction de l'amplitude du signal d'émission, afin de régler la tension d'alimentation (Vcc) de l'amplificateur cadencé.

3. Unité d'émission (10) selon la revendication 2, dans laquelle une tension d'alimentation continue nominale est prévue, la tension d'alimentation (Vcc) de l'amplificateur cadencé est réglable en fonction de la tension d'alimentation continue nominale et du signal de compensation (SFB) dans une plage comprise entre la moitié de la tension d'alimentation continue nominale et le double de la tension d'alimentation continue nominale, en particulier dans une plage d'environ 4 volts à environ 10 volts.

4. Unité d'émission (10) selon l'une des revendications précédentes, comportant un convertisseur CC/CC (24) qui est agencé pour générer la tension d'alimentation (Vcc) à partir d'une tension du réseau de bord de niveau supérieur (VB) en fonction de l'amplitude du signal d'émission ou en fonction du signal de compensation (SFB).

5. Unité d'émission (10) selon l'une des revendications précédentes, dans laquelle le signal de compensation (SFB) délivré par le circuit de compensation (14) est analogique ou numérique.

6. Unité d'émission (10) selon l'une des revendications 2 à 5, dans laquelle l'unité d'émission (10) comprend un processeur (16) qui est agencé pour générer le signal de compensation
(SFB) sous forme numérique en tant que séquence d'horloge avec un rapport cyclique, et de le transmettre au circuit de compensation (14), le rapport cyclique étant réglé par le processeur (16) en fonction de l'amplitude du signal d'émission.

7. Unité d'émission (10) selon la revendication 6, dans laquelle le circuit de compensation (14) délivre la séquence d'impulsions sous forme de signal de compensation (SFB) sous forme numérique en tant que signal de commande pour les commutateurs à semi-conducteurs du convertisseur CC/CC (24).

8. Unité d'émission (10) selon la revendication 6, dans laquelle le circuit de compensation (14) comporte un filtre qui génère, à partir de la séquence d'horloge, le signal de compensation (SFB) sous forme de niveau de tension analogique et le délivre à une entrée de commande du convertisseur CC/CC (24).

9. Unité d'émission (10) selon l'une des revendications précédentes, dans laquelle deux canaux d'émission peuvent recevoir le signal d'émission, l'unité d'émission (10) pouvant être commutée entre les deux canaux d'émission, et dans laquelle la tension d'alimentation (Vcc) de l'amplificateur cadencé ou le signal de compensation peut être commuté en alternance, en fonction du canal d'émission, entre une première et une deuxième tension d'alimentation ou entre un premier et un deuxième signal de compensation (SFB).

10. Unité d'émission (10) selon l'une des revendications précédentes, dans laquelle le circuit de compensation (14) comporte un capteur de température (508) destiné à la détection de la température, et dans laquelle la tension d'alimentation (Vcc) de l'amplificateur cadencé ou le signal de compensation (SFB) dépend de la température détectée.

11. Unité d'émission (10) selon l'une des revendications précédentes, dans laquelle le circuit amplificateur (12) est agencé pour générer une modulation du signal d'émission en fonction d'un signal de référence binaire (TX0, TX1).

12. Unité d'émission (10) selon l'une des revendications précédentes, dans laquelle l'amplificateur cadencé comporte un circuit en demi-pont avec des commutateurs de puissance à semi-conducteurs ou dans laquelle le circuit amplificateur (12) comporte un circuit amplificateur de classe D.

13. Onduleur photovoltaïque (30) comprenant une unité d'émission (10) selon l'une des revendications précédentes, dans lequel l'unité d'émission (10) est prévue pour injecter le signal d'émission dans la ligne de tension continue (26.1, 26.2), un bus CC (26) comprenant les lignes de tension continue (26.1, 26.2), et le bus CC (26) reliant l'onduleur (30) à au moins un générateur photovoltaïque (36) pour le transfert de puissance électrique.

14. Installation photovoltaïque (40) comprenant un onduleur (30) selon la revendication 13, ledit au moins un générateur photovoltaïque (36) et le bus CC (26) pour le transfert de puissance électrique.

15. Procédé d'injection d'un signal d'émission dans une ligne à courant continu (26.1, 26.2), le signal d'émission étant présent entre deux bornes de sortie (20) qui sont reliées à un moyen d'injection (21) dans la ligne à courant continu (26.1, 26.2), dans lequel un circuit amplificateur (12) comprenant un amplificateur cadencé génère le signal d'émission avec une amplitude proportionnelle à une tension d'alimentation (Vcc) de l'amplificateur cadencé, un circuit de compensation (14) détectant l'amplitude du signal d'émission par une mesure de tension différentielle au niveau des bornes de sortie (20) et réglant la tension d'alimentation (Vcc) de l'amplificateur cadencé.
